## Europäisches Patentamt
## European Patent Office
## Office européen des brevets

(19)

(11) Publication number: **0 016 670**
**B1**

(12) **EUROPEAN PATENT SPECIFICATION**

(45) Date de publication du fascicule du brevet: **04.05.83**

(21) Numéro de dépôt: **80400201.2**

(22) Date de dépôt: **08.02.80**

(51) Int. Cl.³: **F 25 B 29/00,**
**F 25 B 21/02, H 01 L 35/32**
**//B60H1/00**

(54) Installation thermoélectrique.

(30) Priorité: **22.02.79 FR 7904597**

(43) Date de publication de la demande:
**01.10.80 Bulletin 80/20**

(45) Mention de la délivrance du brevet:
**04.05.83 Bulletin 83/18**

(84) Etats contractants désignés:
**AT CH DE GB IT SE**

(56) Documents cités:
**FR - A - 1 430 425**
**FR - A - 2 315 771**
**FR - A - 2 353 138**
**US - A - 3 213 630**
**US - A - 3 474 632**
**US - A - 3 626 704**
**US - A - 3 899 359**

(73) Titulaire: **AIR INDUSTRIE**
**5-21 avenue Dubonnet**
**F-92401 Courbevoie (FR)**

(72) Inventeur: **Gaudel, Gérard**
**36, rue des Fossés**
**F-54700 Pont-a-Mousson (FR)**

(74) Mandataire: **Jacquelin, Marc-Henri et al,**
**Cabinet PLASSERAUD 84, rue d'Amsterdam**
**F-75009 Paris (FR)**

Courier Press, Leamington Spa, England.

## Installation thermoélectrique

La présente invention est relative, d'une façon générale, aux installations thermoélectriques comportant des thermoéléments (ou éléments thermoélectriques) montés entre des parois d'échange thermique appartenant à des échangeurs chauds parcourus par un fluide chaud ou à chauffer et à des échangeurs froids parcourus par un fluide froid ou à refroidir.

De telles installations peuvent être utilisées pour engendrer un courant électrique continu lorsque les parois d'échange thermique sont maintenues à des températures différentes par le fluide chaud et le fluide froid, ou, au contraire, pour maintenir les parois d'échange thermique à des températures différentes en vue de chauffer ou de refroidir un fluide par rapport à l'autre lorsque le courant électrique continu circule dans les thermoéléments, ce courant électrique étant amené auxdits thermoéléments par les échangeurs.

L'invention s'applique plus particulièrement, mais non exclusivement, à ces derniers types d'installations, les thermoéléments étant alimentés en courant électrique continu pour entretenir une différence de température entre les parois d'échange thermique. Une telle installation, appelée "pompe à chaleur", peut être utilisée à des fins de climatisation en réchauffant ou en refroidissant un fluide à partir de l'atmosphère ambiante. En effet, les thermoéléments sont de deux types, à savoir les thermoéléments de type P, qui transfèrent des calories dans le sens du courant, et les thermoéléments de type N qui transfèrent des calories dans le sens inverse du courant.

Pour la construction d'installations thermoélectriques, on a déjà proposé de leur faire comporter des empilements d'échangeurs chauds et froids, alternant avec des thermoéléments, le ou les échangeurs de part et d'autre desquels se trouvent les thermoéléments étant ou non isolés électriquement, ces empilements étant disposés côte à côte ou imbriqués (suivant les moyens de liaison électrique des thermoéléments entre eux) de manière à constituer un tiroir d'allure parallélépipédique dans lequel les thermoéléments se trouvent dans des plans parallèles et les échangeurs en regard les uns des autres. Les éléments constitutifs de ce tiroir sont maintenus entre eux par des moyens de fixation et abrités dans un bâti.

Cependant, dans une telle construction, il se pose souvent des problèmes de réalisation car on se trouve, bien entendu, en présence d'un grand nombre de thermoéléments et l'on doit satisfaire à des impératifs d'étanchéité entre les fluides parcourant les échangeurs, de libre dilatation de certaines parties de l'installation, et de montage et de démontage des parties de l'installation comportant les thermoéléments.

Une installation thermo-électrique de ce type est réalisée de telle sorte que l'étanchéité entre les fluides parcourant l'échangeur soit assurée par des moyens fiables et simples, que la dilatation des parties de l'installation qui sont soumises à des gradients de température puisse s'opérer librement et que le démontage et le montage des parties de l'installation portant les thermoéléments soient faciles et rapides.

C'est pourquoi, dans sa demande de brevet français n° 2.315.771, déposée le 27 juin 1975, et dans son premier certificat d'addition n° 2.353.138, déposé le 26 mai 1976, la demanderesse a décrit une installation thermoélectrique comprenant un joint au niveau de chaque plan de thermoélément, ce joint coopérant, par un rebord périphérique, avec une surface d'appui du bâti, l'appui de ce rebord étant obtenu par déplacement relatif du tiroir et du bâti.

Ce mode de réalisation, bien qu'étant fiable et pratique, n'assure pas une étanchéité parfaits entre les fluides traversant, d'une part, les échangeurs chauds, et, d'autre part, les échangeurs froids, et, ce, notamment au niveau des liaisons entre tiroirs ou entre tiroirs et bâti.

Pour remédier à cet état de fait, la présente invention a pour but une installation thermoélectrique, réalisée de telle sorte qu'entre les tiroirs, ou entre les tiroirs et le bâti, les veines fluides chaudes et froides ne puissent exister simultanément, et ceci en conservant les avantages suivants, à savoir: utilisation de moyens fiables et simples; libre dilatation des parties de l'installation qui sont soumises à des gradients de température; et démontage et montage de l'installation faciles et rapides.

Selon l'invention, les courants fluides chaud et froid ont des directions perpendiculaires et il est prévu:

— des cloisons de liaisons des rebords périphériques des joints entre eux sur deux de leurs côtés opposés, parallèles au sens d'écoulement des fluides;
— des éléments de liaison étanches et démontables, entre deux faces opposés du tiroir et le bâti, ces éléments de liaison étant constitués chacun de deux plaques d'appui se faisant face, situées dans des plans parallèles au sens de coulissement du tiroir, et reliées entre elles par un collier démontable, une des plaques d'appui étant solidarisée au tiroir par une bande de matériau adhésif, tandis que l'autre est fixée de manière rigide contre le bâti, chaque plaque d'appui comportant des ouvertures coïncidant avec les passages respectifs d'un des fluides à travers le tiroir.

Grâce à l'invention, les cloisons et les joints forment des canaux étanches pour l'écoulement des fluides dans le tiroir et assurent une étanchéité entre les canaux d'écoulement des veines fluides chaudes et froides. La réalisation de ces canaux étanches facilite également la liaison du tiroir et du bâti ou la liaison des tiroirs entre eux.

L'invention consiste, mise à part la disposition dont il vient d'être question ci-dessus, en d'autres dispositions qui s'utilisent de préférence en même temps et qui seront décrites plus en détail ci-après.

L'invention pourra, de toute façon, être bien comprise à l'aide du complément de description qui suit ainsi que des dessins ci-annexés, lesquels complément et dessins sont relatifs à diverses réalisations et variantes de l'invention.

La figure 1, de ces dessins, est une vue schématique partielle, en perspective, d'une installation selon l'invention.

La figure 2 est une vue schématique en coupe d'une installation selon l'invention.

La figure 3 est une vue schématique en coupe suivant la ligne III—III de la figure 2 d'une installation selon l'invention.

La figure 4 est une vue schématique en coupe du même type que la figure 2 d'une première variante d'installation selon l'invention.

La figure 5 est une vue schématique en coupe du même type que la figure 2 d'une deuxième variante d'installation selon l'invention.

La figure 6, enfin, est une vue schématique en coupe selon VI—VI de la figure 5 d'une deuxième variante d'installation selon l'invention.

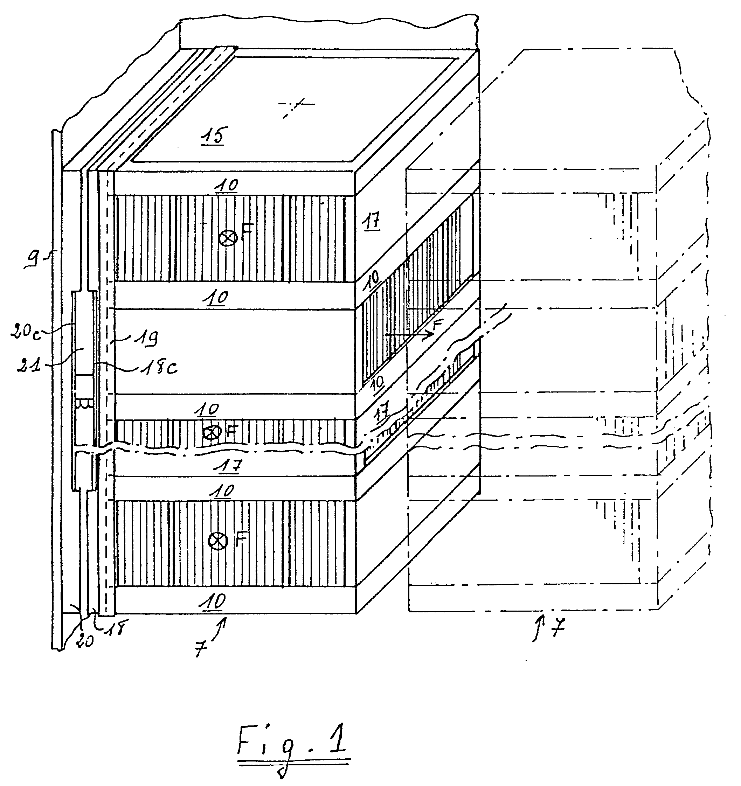

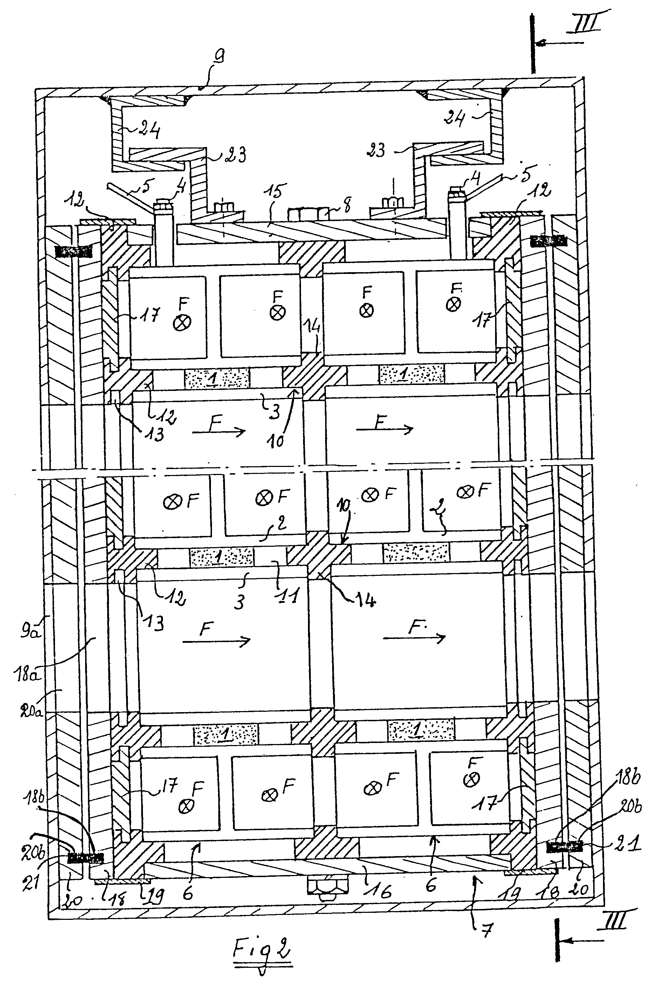

Sur les figures 1 à 3, on a représenté une installation thermoélectrique du type "pompe à chaleur" dans laquelle les thermoéléments, désignés d'une façon générale par le chiffre de référence 1, sont alimentés en courant électrique continu pour entretenir une différence de température entre les parois d'échange thermique 2 et 3, de part et d'autre de chaque thermoélément 1. Ces parois d'échange thermique 2 et 3 appartiennent à des échangeurs chauds parcourus par un fluide chaud et à des échangeurs froids parcourus par un fluide froid, les sens de circulation de ces fluides chaud et froid étant repérés sur les figures 1 et 2 par les flèches F.

En ce qui concerne l'alimentation en courant électrique continu des thermoéléments 1, elle peut se faire au moyen de connexion 4 alimenté par des fils 5, et par l'intermédiaire des échangeurs de chaleur qui sont donc parcourus par le courant électrique qui traverse les thermoéléments 1. Pour la construction de telles installations thermoélectriques, on a déjà proposé de leur faire comporter des empilements 6 d'échangeurs chauds et froids alternant avec les thermoéléments 1, le ou les échangeurs de part et d'autre desquels se trouvent les thermoéléments n'étant pas isolés électriquement et pouvant former un ensemble monobloc; ces empilements 6 sont disposés côte à côte et la liaison électrique des thermoéléments entre eux se fait au travers des échangeurs suivant un parcours rectiligne (montage en colonne).

Cependant, suivant une variante de cette construction, le ou les échangeurs de part et d'autre desquels se trouvent les thermoéléments peuvent être isolés électriquement; les empilements étant alors imbriqués et la liaison électrique des thermoéléments entre eux se faisant par la base des échangeurs et suivant un parcours en grecque (montage en pont).

De toute façon, et quel que soit le type de montage adopté les empilements d'échangeurs disposés côte à côte ou imbriqués constituent un tiroir 7 d'allure parallélépipédique dans lequel les thermoéléments se trouvent dans des plans parallèles et les échangeurs en regard les uns des autres. Les éléments constitutifs de ce tiroir sont maintenus entre eux par des moyens de fixation tels, par exemple, qu'un tirant central 8, et abrités dans un bâti 9 dans lequel sont ménagés des passages 9a permettant la circulation du fluide chaud et du fluide froid.

Un joint 10 est prévu au niveau de chaque plan des thermoéléments, ce joint étant constitué par une plaque comportant autant d'ouvertures 11 qu'il y a de thermoéléments 1 dans le susdit plan, ce joint se trouvant pincé entre les parois 2 et 3 en regard des échangeurs chauds et froids et comportant, en outre, un rebord périphérique 12 pourvu, sur ses faces supérieure et inférieure, d'une gorge continue 13, ce rebord péripherique en relief, venant ceinturer les échangeurs disposés à la périphérie du tiroir 7.

Chaque joint 10 peut avantageusement comporter, comme montré sur la figure 2, des nervures centrales en relief 14 qui viennent s'interposer entre les échangeurs du tiroir 7 pour, d'une part, assurer l'étanchéité entre les échangeurs et, d'autre part, jouer le rôle d'entretoises assurant le positionnement relatif des échangeurs entre eux avec une effet de suspension et d'amortissement des vibrations.

Bien entendu, les deux joints 10, situés aux deux extrémités du tiroir 7, sont agencés différemment pour coopérer respectivement avec deux pièces d'extrémité 15, 16 sollicitées l'une vers l'autre par le tirant central 8.

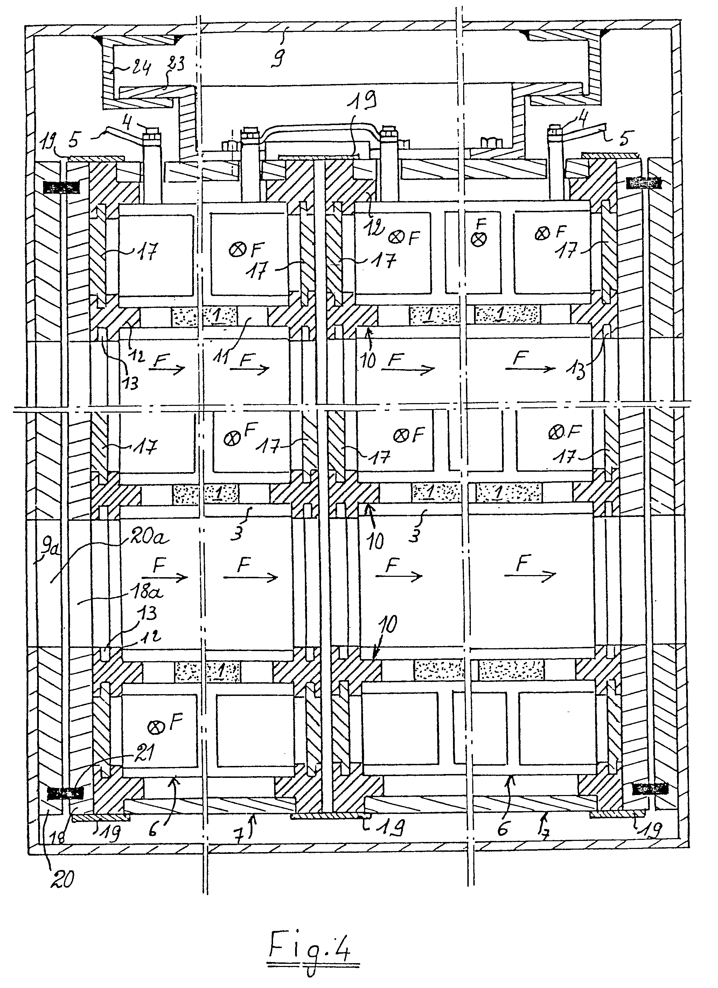

Des cloisons de liaison 17, comme montré sur les figures 1, 2, 4 et 5, relient les joints 10, par leur rebord périphérique 12 où ces cloisons de liaison 17 sont encastrées dans la gorge continue 13, sur deux de leurs côtés opposés, parallèles au sens d'écoulement des fluides. Ainsi, ces cloisons de liaison 17 forment, avec les joints 10 et les parois d'échange thermique 2 et 3, des conduits étanches de circulation des fluides chaud ou froid dans le tiroir 7.

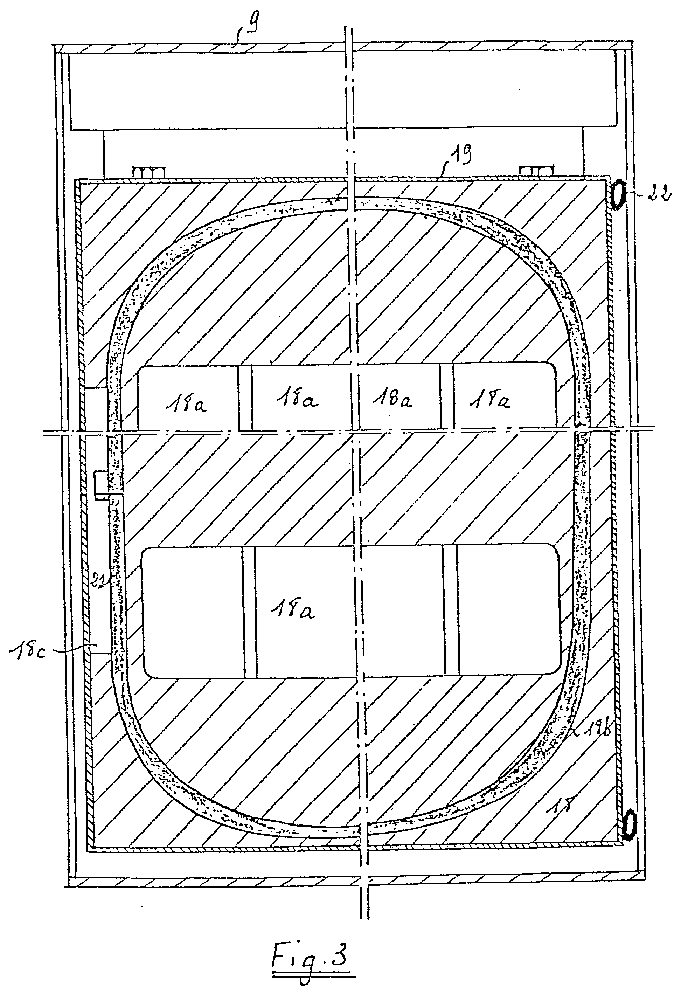

Des dipositifs de liaison entre le tiroir 7 et le bâti 9 sont prévus pour assurer la continuité des passages 9a du bâti 9 avec les espaces des échangeurs correspondants du tiroir 7. C'est ainsi, tel que représenté sur les figures 1 à 6 et en particulier sur la figure 3, qu'une première plaque d'appui 18 est appliquée contre une face latérale du tiroir 7 et fixée à celui-ci par une bande de matériau adhésif 19 l'entourant et venant adhérer sur les rebords des joints 10 et sur les cloisons de liaison 17. La plaque d'appui 18 comporte des ouvertures 18a, correspondant aux passages 9a du bâti, et une gorge 18b, de forme générale elliptique, entourant les ouvertures 18a et débouchant par une fenêtre 18c. Face à cette première plaque d'appui 18, une seconde plaque d'appui 20, avec ses ouvertures 20a et ses fenêtres 20c, identique, est fixée sur le bâti 9. Un collier 21, métallique ou composite (métal et matériau élastique), est introduit, par les fenêtres 18c et 20c des plaques 18 et 20, dans les deux gorges 18b et 20b pour assurer la liaison des plaques d'appui 18 et 20 entre elles. Ainsi, il y a étanchéité entre les conduits des tiroirs et les passages correspondants du bâti. Dans ce conditions, le fluide chaud ne peut pas se mélanger avec le fluide froid.

Pour assurer l'étanchéité des deux autres faces latérales du tiroir 7, un joint d'étanchéité 22, fixé au bâti 9, entoure l'ensemble des passages 9a. Ainsi, lorsque le tiroir 7, suspendu par deux profilés d'appui 23 solidaires de la pièce d'extrémité 15 coopérant avec deux glissières 24 solidaires du bâti 9, est placé dans le bâti, il est poussé contre le joint d'étanchéité 22, comme représenté sur la figure 3.

Il est également possible de placer côté à côte plusieurs tiroirs dans un même bâti 9. Une telle disposition est représentée sur les figures 1, 4 et 6. Dans ce cas, l'étanchéité entre tiroirs est réalisée par une bande de matériau adhésif 19 entourant les deux extrémités adjacentes des tiroirs voisins et venant adhérer sur les rebords des joints 10 et sur les cloisons de liaison 17 de chacun des tiroirs. Seules les deux faces des tiroirs extrêmes, proches du bâti, sont munies de plaques d'appui 18 destinées à être solidarisées aux plaques d'appui 20 du bâti 9. De même, il est possible de prévoir, dans un même bâti, plusieurs séries de tiroirs reliés entre eux par une bande de matériau adhésif 19, les séries étant reliées entre elles par des plaques d'appui et un collier identique à ceux des extrémités.

On conçoit finalement que l'on dispose alors d'une installation thermoélectrique dans laquelle l'étanchéité entre le fluide chaud et le fluide froid est assurée par des moyens fiables et simples puisque, dans le bâti, il ne peut y avoir aucun contact entre les fluides chaud et froid, l'un des fluides étant parfaitement canalisé dans les tiroirs par les joints 10 et les cloisons de liaison 17; entre les tiroirs par la bande de matériau adhésif 19; entre les tiroirs et le bâti, par les plaques d'appui 18 et 20 et le collier 21.

Par ailleurs, l'agencement du tiroir dans son bâti permet au tiroir de se dilater librement puisque les liaisons sont assurées par une bande de matériau adhésif 19 et un collier 21.

De plus, la rigidité du tiroir est améliorée par la présence des cloisons de liaison entre joints.

Enfin, la facilité de montage et de démontage du tiroir, par pose ou dépose du collier 21, permet un entretien et un remplacement faciles de celui-ci.

La liaison entre les tiroirs et/ou entre un tiroir et sa plaque d'appui 18, étant assurée par une bande de matériau adhésif, il est possible de prévoir un certain espace entre tiroirs ou entre le tiroir et le bâti. Cet espace peut permettre de recevoir l'eau contenue dans l'air et condensée au contact des surfaces d'échange thermique. Ainsi, cette eau peut être évacuée facilement par gravité dans le "puits" formé entre tiroirs et/ou entre tiroir et bâti.

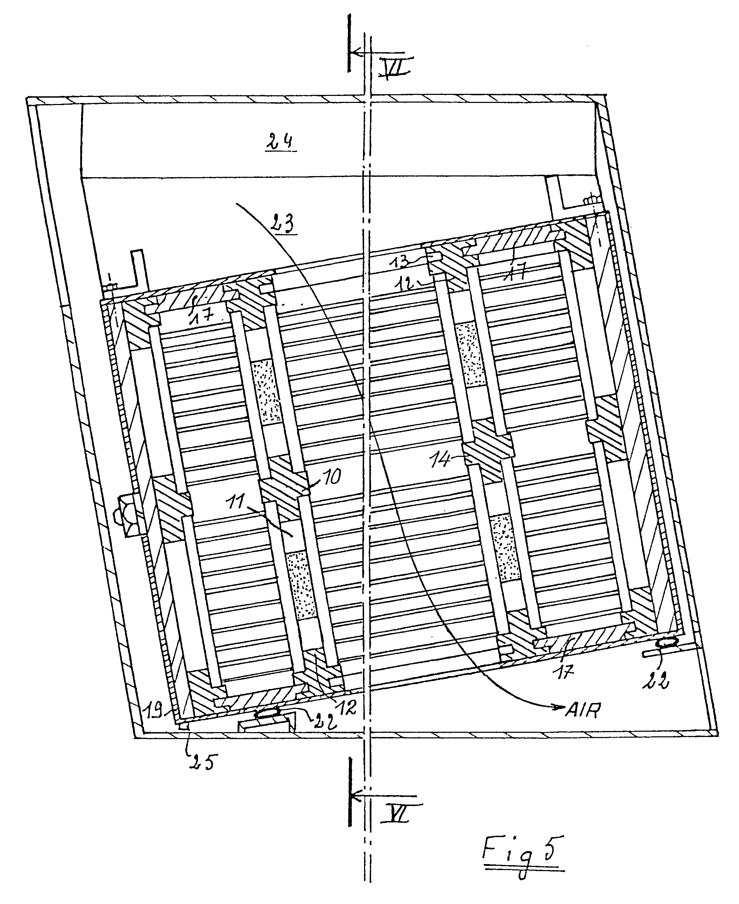

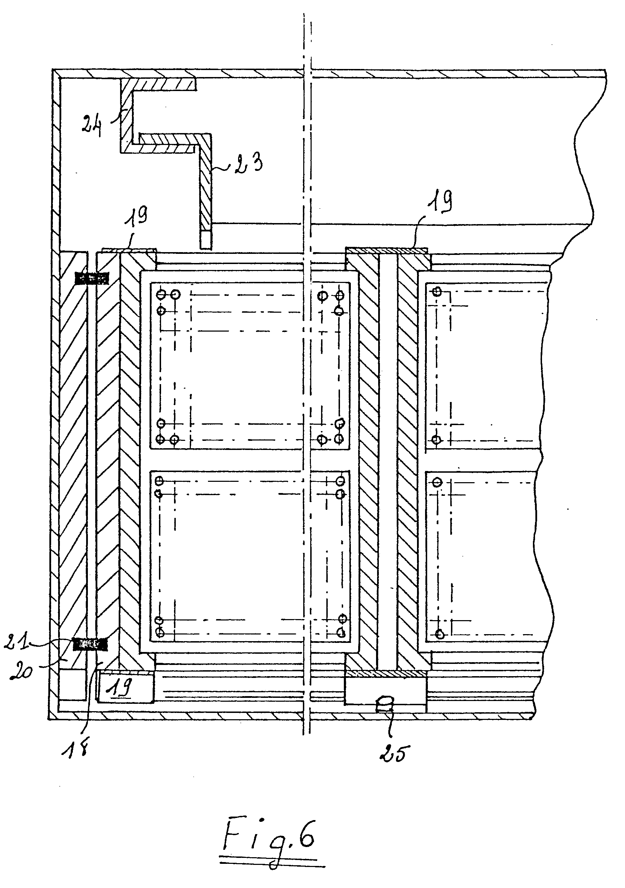

D'ailleurs, pour faciliter l'évacuation de cette eau de condensation formée au contact des surfaces d'échange thermique, il est possible d'incliner le ou les tiroirs dans le bâti 9 et d'assurer l'évacuation de cette eau par un conduit 25 débouchant, au point bas, dans l'espace situé entre tiroirs et/ou tiroir et bâti. Une telle installation est représentée sur les figures 5 et 6.

La présente invention trouve donc une application particulièrement avantageuse dans la climatisation (chauffage et refroidissement) des voitures de chemin de fer qui peuvent alors comporter, sous leur châssis, toute une série de bâti abritant chacun un tiroir. Dans une telle application, on conçoit que les problèmes d'étanchéité, de libre dilatation et de facilité de montage et de démontage sont particulièrement importants et que les avantages procurés par l'invention n'en seront que plus appréciés. De plus, l'effet de suspension et d'amortissement des vibrations provoqué par les joints et le système de suspension de tiroirs permettra à l'installation de mieux résister aux conditions d'utilisation dans les voitures de chemin de fer.

Comme il va de soi et comme il résulte d'ailleurs déjà de ce qui précède, l'invention ne se limite nullement à celui de ses modes d'application, non plus qu'à ceux des modes de réalisation de ses diverses parties, ayant été particulièrement envisagés; elle en embrasse, au contraire, toutes les variantes.

## Revendications

1. Installation thermoélectrique, notamment pompe à chaleur, comportant des thermoéléments (1) montés entre des parois d'échange thermique (2, 3) appartenant à des échangeurs chauds parcourus par un fluide chaud et à des échangeurs froids parcourus par un fluide froid, lesdits échangeurs chauds et froids alternant avec des thermoéléments (1) pour former des empilements disposés côte à côte ou imbriqués de manière à constituer au moins un tiroir (7) d'allure parallélépipédique dans lequel les thermoéléments (1) se trouvent dans des plans parallèles et les échangeurs en regard les uns des autres, les courants des fluides chauds et froids ayant des directions perpendiculaires, les éléments constitutifs de ce tiroir (7) étant maintenus entre eux par des moyens de fixation (8) et abrités dans un bâti (9), et un joint (10) au niveau de chaque plan des thermoéléments (1), ce joint (10) étant constitué par une plaque comportant autant d'ouvertures (11) qu'il y a de thermoéléments (1) dans le susdit plan, ce joint (10) se trouvant pincé entre les parois (2, 3) en regard de l'échangeur chaud et de l'échangeur froid et comportant, en outre, un rebord périphérique (12), caractérisée en ce qu'il est prévu:

— des cloisons de liaison (17) des rebords périphériques (12) des joints (10) entre eux sur deux de leurs côtés opposés, parallèles au sens d'écoulement des fluides;
— des éléments de liaison étanches et démontables, entre deux faces opposées du tiroir (7) et le bâti (9), ces éléments de liaison étant constitués chacun de deux plaques d'appui (18, 20) se faisant face, situées dans des plans parallèles au sens de coulissement du tiroir (7), et reliées entre elles par un collier démontable (21), une des plaques d'appui (18) étant solidarisée au tiroir (7) par une bande de matériau adhésif (19), tandis que l'autre (20) est fixée de manière rigide contre le bâti (9), chaque plaque d'appui (18, 20) comportant des ouvertures (18a, 20a) coïncidant avec les passages respectifs d'un des fluides à travers le tiroir.

2. Installation thermoélectrique selon la revendication 1, et comportant plusieurs tiroirs (7), caractérisée en ce qu'il est prévu des éléments de liaison étanches et démontables entre les tiroirs (7), ces éléments de liaison étant constitués par un ruban adhésif (19) entourant et chevauchant les deux tiroirs (7) situés côte à côte.

3. Installation thermoélectrique selon la revendication 1 ou 2, caractérisée en ce que les cloisons de liaison (17) sont encastrées dans une gorge continue (13) ménagée dans le rebord périphérique (12) du joint (10).

4. Installation thermoélectrique selon les revendications 1 à 3, caractérisée en ce que chaque plaque d'appui (18, 20) comporte une gorge (18b, 20b) entourant les ouvertures (18a, 20a) et débouchant par une fenêtre (18c, 20c) le collier (21) étant introduit par les deux susdites fenêtres (18c, 20c) dans les deux susdites gorges (18b, 20b).

5. Installation thermoélectrique selon l'une quelconque des revendications 1 à 4, comportant de préférence plusieurs tiroirs, caractérisée en ce qu'un espace est prévu entre les tiroirs (7) ou entre le tiroir (7) et le bâti (9).

6. Installation thermoélectrique selon l'une quelconque des revendications 1 à 5, comportant de préférence plusieurs tiroirs, caractérisée en ce que le ou les tiroirs (7) sont inclinés par rapport au bâti (9), des moyens d'évacuation de l'eau (25) étant prévus au point bas de l'espace situé entre le ou les tiroirs (7) et le bâti (9).

**Patentansprüche**

1. Thermoelektrische Anlage, insbesondere Wärmepumpe, mit Thermoelementen (1), die zwischen Wäremaustauschwänden (2, 3) montiert sind, welche von einem warmen Fluid durchströmten warmen Austauschern und von einem kalten Fluid durchströmten kalten Austauschern angehören, wobei die warmen und die kalten Austauscher mit den Thermoelementen abwechseln, um Stapel zu bilden, die nebeneinander oder ineinander verschachtelt angeordnet sind und zumindest eine Schublade (7) mit parallelepipedischer Gestalt bilden, in welcher die Thermoelemente (1) in parallelen Ebenen angeordnet sind und die Austauscher einander gegenüberliegen, wobei ferner die Richtungen der Ströme des warmen und des kalten Fluids aufeinander senkrecht stehen, und wobei die die Schublade (7) bildenden Elemente untereinander durch Befestigungsmittel (8) gehalten in einem Raum (9) geschützt sind und auf dem Niveau jeder Ebene der Thermoelemente (1) eine Dichtung (10) vorgesehen ist, die durch eine Platte mit so viel Durchtrittsöffnungen (11) gebildet ist, wie Thermoelemente (1) in dieser Ebene vorhanden sind, und zwischen den einander gegenüberliegenden Wänden (2, 3) des warmen und des kalten Austauschers eingespannt und außerdem mit einer Umfangsrandleiste (12) versehen ist, gekennzeichnet durch:

— Verbindungswände (17), welche mit zwei ihnen gegenüberliegenden, parallel zur Strömungsrichtung der Fluide verlaufenden Seiten zwischen den Umfangsrandleisten (12) der Dichtungen (10) angeordnet sind;
— dichte und demontierbare Verbindungselemente zwischen zwei einander gegenüberliegenden Flächen der Schublade (7) und des Rahmens (9), wobei diese Verbindungselemente je aus zwei Stützplatten (18, 20) gebildet sind, die in zur Gleitrichtung der Schublade (7) parallelen Ebenen einander gegenüber liegen und untereinander durch einen demontierbaren Ring (21) verbunden sind, wobei eine der Stützplatten (18) mit der Schublade (7) durch ein Band (19) aus Klebematerial verbunden ist, während die andere (20) am Rahmen (9) starr befestigt ist, und jede Stützplatte (18, 20) Öffnungen (18a, 20a) aufweist, die mit den betreffenden Strömungswegen eines der Fluids durch die Schublade koinzidieren.

2. Thermoelektrische Anlage Anspruch 1, mit einer Vielzahl von Schubladen (7), dadurch gekennzeichnet, daß zwischen den Schubladen (7) abdichtende und demontierbare Verbindungselemente vorgesehen sind, die durch ein Klebeband (19) gebildet sind, welches die beiden nebeneinander angeordneten Schubladen (7) umgibt und überlappt.

3. Thermoelektrische Anlage nach Anspruch 1 oder 2, dadurch gekennzeichnet, daß die Verbindungswände (17) in einer kontinuierlichen Nut (13) eingespannt sind, die in der Umfangsrandleiste (12) der Dichtung (10) ausgebildet ist.

4. Thermoelektrische Anlage nach einem der Ansprüche 1 bis 3, dadurch gekennzeichnet, daß jede Stützplatte (18, 20) eine Nut (18b, 20b) aufweist, welche die Öffnungen (18a, 20a) umgibt und durch ein Fenster (18c, 20c) ausmündet, wobei der Ring (21) durch die beiden Fenster (18c, 20c) hindurch in die beiden Nuten (18b, 20b) eingeführt wird.

5. Thermoelektrische Anlage nach einem der Ansprüche 1 bis 4, die vorzugsweise mehrere Schubladen aufweist, dadurch gekennzeichnet, daß zwischen den Schubladen (7) oder zwischen der Schublade (7) und dem Rahmen (9) ein Raum vorgesehen ist.

6. Thermoelektrische Anlage nach einem der Ansprüche 1 bis 5, die vorzugsweise mehrere Schubladen aufweist, dadurch gekennzeichnet, daß die Schublade oder die Schubladen (7) gegenüber den Rahmen (9) geneigt angeordnet sind, und daß an einer unteren Stelle des Raumes zwischen der Schublade oder den Schubladen (7) und dem Gestell (9) Wasserableitmittel (25) vorgesehen sind.

**Claims**

1. Thermoelectric installation, in particular a heat pump, comprising thermoelements (1) mounted between the heat exchange surfaces (2, 3) forming part of hot exchangers through which a hot fluid passes and of cold exchangers through which a cold fluid passes, the said hot and cold exchangers alternating with the thermoelements (1) so as to form stacks arranged side by side or overlapping in such a manner as to constitute at least one drawer shaped as a parallelipidep inside which the thermoelements (1) are placed in parallel planes and the exchangers facing each other, the currents of hot and cold fluids travelling in perpendicular directions, the constituent parts of this drawer (7) being maintained in position by some means of fixing (8) and housed in a stand (9), and a connecting piece (10) at the level of each plane of thermoelements (1), this connecting piece (10) having the form of a plate with as many openings (11) as there are thermoelements (1) in the above mentioned plane, this connecting piece (10) being gripped between the surfaces (2, 3) opposite to the hot exchanger and the cold exchanger and provided in addition with a rim (12) round the edge, characterised in that it is provided with:

— linking pieces (17) connecting the rims (12) with the connecting pieces (10) on two of their opposite surfaces, parallel to the direction of flow of the fluids;

— air-tight removable linking elements between two opposite surfaces of the drawer (7) and the stand (9), these linking elements each consisting of two support plates (18, 20) facing each other, situated in planes parallel to the direction in which the drawer (7) slides, and connected together by a removable collar (21), one of these support plates (18) being fixed to the drawer (7) by a strip of adhesive material (19), whilst the other (20) is rigidly fixed to the stand (9), each support plate (18, 20) being provided with openings (18a, 20a) which coincide with the respective passages of one of the fluids through the drawer.

2. Thermoelectric installation as in claim 1, provided with more than one drawer (7), characterised in that air-tight removable linking elements are provided between the drawers (7), these linking elements taking the form of an adhesive tape (19) surrounding and adhering to the two drawers (7) situated side by side.

3. Thermoelectric installation as in claim 1 or 2, characterised in that the linking pieces (17) are housed in a continuous groove (13) in the rim (12) of the connecting piece (10).

4. Thermoelectric installation as in claims 1 to 3, characterised in that each support plate (18, 20) is provided with a groove (18b, 20b) which surrounds the openings (18a, 20a) and which leads to an aperture (18c, 20c), the collar (21) being introduced through the above mentioned apertures (18c, 20c) into the two above mentioned grooves (18b, 20b).

5. Thermoelectric installation as in any one of claims 1 to 4, preferably having more than one drawer, characterised in that there is a space between the drawers (7) or between the drawer (7) and the stand (9).

6. Thermoelectric installation as in any one of claims 1 to 5, preferably having more than one drawer, characterised in that the drawer(s) (7) are at an inclination to the stand (9), and that some means of evacuation of water (25) is provided at the lowest point of the space between the drawer(s) (7) and the stand (9).

_Fig. 1_

Fig 2

Fig. 3

Fig.4

0 016 670

Fig 5

Fig.6